(19) Europäisches Patentamt / European Patent Office / Office européen des brevets

(11) **EP 2 618 164 B1**

(12) **FASCICULE DE BREVET EUROPEEN**

(45) Date de publication et mention
de la délivrance du brevet:
**16.07.2014 Bulletin 2014/29**

(51) Int Cl.:
***G01P 15/125*** *(2006.01)*     ***G01L 1/14*** *(2006.01)*

(21) Numéro de dépôt: **12151951.6**

(22) Date de dépôt: **20.01.2012**

(54) **Procédé de mesure d'un paramètre physique et circuit électronique d'interface d'un capteur capacitif pour sa mise en oeuvre**

Verfahren zum Messen eines physikalischen Parameters, und elektronischer Schnittstellenschaltkreis eines kapazitiven Sensors zur Umsetzung dieses Verfahrens

Method for measuring a physical parameter and electronic circuit to interface with a capacitive sensor for implementing same

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**24.07.2013 Bulletin 2013/30**

(73) Titulaire: **EM Microelectronic-Marin SA
2074 Marin (CH)**

(72) Inventeurs:
• **Entringer, Christophe
1426 Corcelles-près-Consise (CH)**

• **Grosjean, Sylvain
25500 Les Fins (FR)**

(74) Mandataire: **Ravenel, Thierry Gérard Louis et al
ICB
Ingénieurs Conseils en Brevets SA
Faubourg de l'Hôpital 3
2001 Neuchâtel (CH)**

(56) Documents cités:
**EP-A1- 1 835 263     EP-A1- 2 343 507
WO-A1-2008/107737     WO-A2-2006/070272
US-A1- 2009 241 666**

**Description**

L'invention concerne un procédé de mesure d'un paramètre physique, tel qu'une accélération, une vitesse angulaire, une force ou une pression, au moyen d'un circuit électronique d'interface relié à un capteur capacitif.

L'invention concerne également un circuit électronique d'interface d'un capteur capacitif pour la mise en oeuvre du procédé de mesure. Le capteur capacitif est composé d'au moins deux condensateurs montés en différentiel. Une électrode commune des condensateurs est susceptible de se déplacer entre deux électrodes fixes sous l'action par exemple d'une force pour modifier la valeur capacitive de chaque condensateur.

Dans une conception traditionnelle simple d'un tel capteur capacitif, l'électrode commune, qui est mobile, fait partie d'une armature maintenue élastiquement entre les deux électrodes fixes. Dans ce cas, le capteur capacitif peut être capable d'opérer une mesure selon une direction de mouvement de l'électrode mobile. Au repos, cette électrode commune mobile se trouve normalement à égale distance de l'une et de l'autre électrode fixe pour avoir des capacités de valeur égale des deux condensateurs. L'électrode commune mobile peut se déplacer d'une certaine distance en direction de l'une ou l'autre des électrodes fixes sous l'action notamment d'une force. Ainsi la valeur capacitive de chaque condensateur varie inversement. Le circuit électronique d'interface relié au capteur capacitif permet ainsi de fournir un signal de sortie analogique. Ce signal de sortie analogique est défini sous la forme d'une tension dépendant de la variation des capacités des deux condensateurs.

Un tel circuit électronique d'interface d'un capteur capacitif est décrit dans l'article rédigé par MM. H. Leuthold et F. Rudolph, qui est paru dans la revue intitulée "Sensors and actuators" A21-A23 (1990), pages 278 à 281.

Le capteur capacitif peut être un accéléromètre pour effectuer une mesure d'accélération en liaison avec un circuit électronique d'interface. Il peut s'agir d'un accéléromètre uniaxe comme le capteur capacitif susmentionné ou d'un accéléromètre multiaxe ou triaxial pour effectuer une mesure dans les trois directions X, Y et Z. Un tel accéléromètre triaxial du type MEMS peut comprendre une masse unique, c'est-à-dire une masse inertielle commune aux trois paires de condensateurs différentiels, ou trois masses pour les trois paires de condensateurs. Dans le premier cas, une seule électrode commune et six électrodes fixes sont prévues, alors que pour le second cas, une électrode commune avec deux électrodes fixes sont prévues pour chaque paire de condensateurs.

Aussi bien le circuit électronique, que le capteur capacitif, tel qu'un accéléromètre MEMS, sont réalisés chacun dans un substrat semi-conducteur. De ce fait, des capacités parasites à l'entrée du circuit électronique s'ajoutent aux capacités des condensateurs du capteur capacitif MEMS. Ces capacités parasites ne dépendent pas du déplacement de l'électrode mobile, ce qui a pour conséquence de créer des non-linéarités et également de faire baisser la sensibilité ou le gain du circuit électronique. Il en est de même avec le capteur capacitif MEMS, où le potentiel du substrat lors du fonctionnement du capteur crée également des non-linéarités. Ainsi la force électrostatique mesurée n'est pas nulle dans un mode de repos du capteur et du circuit électronique. De par l'influence du potentiel du substrat sur la force électrostatique, cela conduit à une variation de la force réelle mesurée, qui est appliquée sur l'électrode commune mobile, ce qui est un inconvénient.

Pour effectuer une mesure d'une force, d'une accélération ou d'une pression par l'intermédiaire du circuit électronique, les électrodes fixes de deux condensateurs ou des paires de condensateurs sont polarisées ou excitées cycliquement par des tensions de polarité opposée par rapport à une tension de référence au repos. En polarisant les deux électrodes fixes à des niveaux de tension différents, la différence de charges sur l'électrode mobile peut être mesurée et convertie en au moins une tension en sortie du circuit électronique. Lorsque la ou les tensions de sortie sont stabilisées à leur valeur finale, la charge totale sur l'électrode mobile devient nulle. Par la suite, ces tensions de sortie sont fournies échantillonnées à un circuit de traitement.

Comme la mesure d'une force, d'une accélération ou d'une pression, est dépendante des non-linéarités susmentionnées et de tout écart de tension lié aux composants électroniques non appariés, la demande de brevet EP 1 835 263 propose une solution à ce problème. Une double structure symétrique dans le circuit électronique est proposée notamment avec deux intégrateurs à la suite de l'amplificateur à transfert de charges. Chaque intégrateur fournit en sortie une tension de sortie analogique correspondante selon une polarisation positive des électrodes ou une polarisation négative des électrodes. Grâce à cela, un écart de tension (offset) dû à la technologie ou à la variation de tension d'alimentation peut être minimisé voire supprimé à l'aide des deux tensions de sortie analogiques des intégrateurs. De plus, le potentiel du substrat n'a plus d'importance comme le circuit électronique comprend une double structure identique à fonctionnement totalement symétrique.

Cependant un inconvénient d'un tel circuit électronique du document de brevet EP 1 835 263, est qu'il fournit des signaux de sortie, tels que des tensions de sortie, sous forme analogique. Ceci nécessite l'emploi de deux intégrateurs. Cela ne permet pas de réduire de manière suffisante la taille des composants intégrés et la consommation électrique du circuit électronique intégré. De plus, ce circuit électronique n'est prévu que pour effectuer une mesure avec un capteur capacitif selon un seul axe de mesure.

Il est donc préféré de réaliser un circuit électronique, qui fournit en sortie des signaux numériques de mesure. A ce titre, on peut citer le document de brevet WO 2004/113930, qui décrit un tel circuit électronique relié à un capteur capacitif uniaxe ou multiaxe pour la mesure d'une accélération. Il est prévu à la suite de l'amplificateur à transfert de charges, qui est relié à l'électrode commune mobile, une logique spécifique à chaque axe de mesure, qui traite des signaux numériques de mesure. Chaque logique fournit en sortie un signal binaire de mesure représentatif d'un niveau de tension de mesure fonction du déplacement de l'électrode mobile par rapport aux électrodes fixes pour chaque axe successivement. Le signal binaire de mesure est fourni successivement pour chaque axe à un convertisseur numérique-analogique. Ce convertisseur fournit dans une phase de chaque cycle de mesure pour un axe sélectionné, une tension de mesure aux électrodes en alternance avec une phase de polarisation des électrodes fixes à une tension haute et une tension basse d'une source de tension d'alimentation. Le signal binaire obtenu en sortie de chaque logique est incrémenté ou décrémenté d'une unité à chaque série de phases de mesure, jusqu'à ce que la charge totale sur l'électrode mobile devienne nulle. Bien que la taille des composants électroniques et la consommation électrique soient réduites, les non-linéarités susmentionnées et les écarts de tension (offset) ne sont pas supprimés, ce qui est un inconvénient. De plus, le temps pour stabiliser le signal numérique de sortie pour chaque axe de mesure est relativement long, ce qui est un autre inconvénient.

Comme pour le précédent document, le document de brevet WO 2008/107737 décrit un circuit électronique d'interface d'un capteur de mesure d'une accélération. Un signal analogique de mesure est mémorisé à la suite d'un amplificateur à transfert de charges dans une phase d'un cycle de mesure suite à une polarisation des électrodes fixes des condensateurs. Le signal analogique est converti en un signal numérique mémorisé dans une logique du circuit électronique. Le signal numérique mémorisé est par la suite converti par un convertisseur numérique-analogique en un signal retour analogique sous forme de tension, qui est appliquée à toutes les électrodes du capteur dans une phase successive de chaque cycle de mesure. Dans un cycle de mesure, les électrodes fixes sont polarisées successivement par une première polarisation et par une seconde polarisation inverse à la première polarisation. Cela permet de supprimer les courants de fuite du circuit électronique. Par contre, beaucoup d'étapes sont nécessaires pour obtenir en sortie un signal de mesure d'un paramètre physique, ce qui constitue un inconvénient.

Dans le document de brevet EP 2 343 507, il est décrit un circuit électronique d'interface d'un capteur de mesure uniaxe ou triaxial. Un traitement numérique des signaux de mesure est effectué à la suite de l'amplificateur à transfert de charges dans une unité logique. Des signaux numériques de mesure suite à une polarisation positive et à une polarisation négative sont mémorisés dans des registres correspondants de l'unité logique. Un convertisseur numérique-analogique est également utilisé pour convertir les signaux numériques successivement pour chaque axe dans un cycle de mesure, en une tension aux électrodes du capteur. Pour obtenir des valeurs finales de mesure de l'accélération pour chaque axe, il est utilisé dans l'unité logique, tout d'abord un algorithme par dichotomie pour un certain nombre de cycles de mesure, avant de terminer par des étapes de sur-échantillonnage. Avec cet algorithme par dichotomie, la mesure débute toujours, lors de chaque conversion, à la moitié de la marge de mesure notamment à $V_{REG}/2$. Si une erreur survient lors de cette première mesure avec un grand pas de changement dans l'unité logique, la valeur finale au terme de tous les cycles de mesure, sera inévitablement fausse, ce qui constitue un inconvénient.

L'invention a donc pour but de pallier aux inconvénients de l'état de la technique susmentionnés en fournissant un procédé de mesure d'un paramètre physique au moyen d'un circuit électronique d'interface relié à un capteur capacitif, qui permet de fournir rapidement et sans erreur des signaux de sortie précis en supprimant également tout écart de tension.

A cet effet, l'invention concerne un procédé de mesure d'un paramètre physique au moyen d'un circuit électronique d'interface relié à un capteur capacitif, qui comprend les caractéristiques définies dans la revendication indépendante 1.

Des étapes particulières du procédé de mesure sont définies dans les revendications dépendantes 2 à 7.

Un avantage du procédé de mesure réside dans le fait qu'au moins un signal numérique de sortie d'une mesure d'un paramètre physique peut être fourni rapidement en sortie du circuit électronique et sans erreur. Par le procédé de mesure, il est défini un bon compromis entre la vitesse de changement par exemple d'une accélération, et de fourniture de signaux de mesure, et la réduction du bruit au moyen des petits pas d'adaptation au terme de chaque conversion.

Un autre avantage du procédé de mesure réside dans le fait qu'il peut être repris directement au terme de chaque conversion le dernier signal numérique mémorisé de chaque registre correspondant, pour pouvoir débuter une conversion de mesure subséquente. Pour débuter une nouvelle conversion, il peut également être utilisé une moyenne finale des signaux numériques successifs stockés dans un registre correspondant dans au moins une partie finale d'une seconde série de cycles de mesure à petits pas d'adaptation. Une sélection de la dernière valeur numérique stockée de chaque signal numérique ou de la moyenne des signaux numériques de la seconde série de cycles de mesure, peut être effectuée sur la base d'un comptage par un compteur de décisions.

Avantageusement en reprenant la précédente valeur numérique du registre de polarisation positive et du registre de polarisation négative de chaque axe de mesure, cela permet de stocker la variation de la conversion précédente et de mémoriser ainsi l'offset précédent. Il n'y a donc plus besoin d'avoir une première série avec beaucoup de cycles de mesure à grands pas d'adaptation. Par contre, il doit être tenu compte d'un bon compromis entre de brusques changements du paramètre physique à mesurer et la réduction du bruit, qui est réalisée avec une seconde série à petits pas dans les cycles de mesure.

A cet effet, l'invention concerne également un circuit électronique d'interface d'un capteur capacitif cité ci-devant pour la mise en oeuvre du procédé de mesure, qui comprend les caractéristiques définies dans la revendication indépendante 8.

Des formes d'exécution spécifiques du circuit électronique sont définies dans les revendications dépendantes 9 à 11.

Un avantage du circuit électronique d'interface d'un capteur physique réside dans le fait qu'il permet d'obtenir rapidement des signaux numériques de mesure stabilisés en sortie grâce à un traitement numérique directement après l'amplificateur à transfert de charges. Ces signaux numériques de mesure sont traités dans l'unité logique. Ces signaux numériques sont adaptés depuis les premiers cycles de mesure en utilisant tout d'abord de grands pas d'adaptation, qui peuvent être programmés, suivis par de petits pas au terme de chaque conversion de mesure. Deux signaux numériques dépendant d'une polarisation positive et d'une polarisation négative des électrodes fixes de la paire de condensateurs, sont fournis dans l'unité logique. Ceci permet par combinaison des signaux numériques de supprimer tout écart de tension notamment des composants du circuit électronique.

Un autre avantage du circuit électronique d'interface d'un capteur physique réside dans le fait qu'il peut fournir deux signaux numériques pour chaque axe d'un capteur triaxial. Un seul amplificateur, une unité logique et un seul convertisseur numérique-analogique sont ainsi prévus pour la mesure du paramètre physique selon les trois axes. Ceci limite la redondance du circuit électronique.

Les buts, avantages et caractéristiques du procédé de mesure d'un paramètre physique et le circuit électronique d'interface d'un capteur capacitif pour sa mise en oeuvre apparaîtront mieux dans la description suivante en regard des dessins sur lesquels :

- la figure 1 représente de manière simplifiée un circuit électronique d'interface relié à un capteur capacitif pour la mise en oeuvre du procédé de mesure d'un paramètre physique selon l'invention,
- les figures 2a et 2b représentent des diagrammes temporels comparatifs selon un axe de mesure d'une part en partant du milieu de la marge de mesure pour chaque conversion successive de mesure, et d'autre part en partant de la valeur d'une précédente conversion dans le cas d'aucune accélération et d'un offset maximum du procédé de mesure selon l'invention,
- les figures 3a et 3b représentent des diagrammes temporels comparatifs selon un axe de mesure d'une part en partant du milieu de la marge de mesure pour chaque conversion successive de mesure, et d'autre part en partant de la valeur d'une précédente conversion dans le cas d'une accélération maximum et d'un offset maximum du procédé de mesure selon l'invention, et
- la figure 4 représente un diagramme temporel selon un axe de mesure d'un changement maximum d'accélération entre deux conversions successives de mesure en considérant l'offset nul du procédé de mesure selon l'invention.

Dans la description suivante comme différents composants du circuit électronique d'interface d'un capteur à condensateurs différentiels sont bien connus dans ce domaine technique, ils ne seront pas tous explicités en détail. L'accent porte principalement sur le procédé de mesure du paramètre physique au moyen d'un circuit électronique qui fournit des signaux numériques de mesure en sortie.

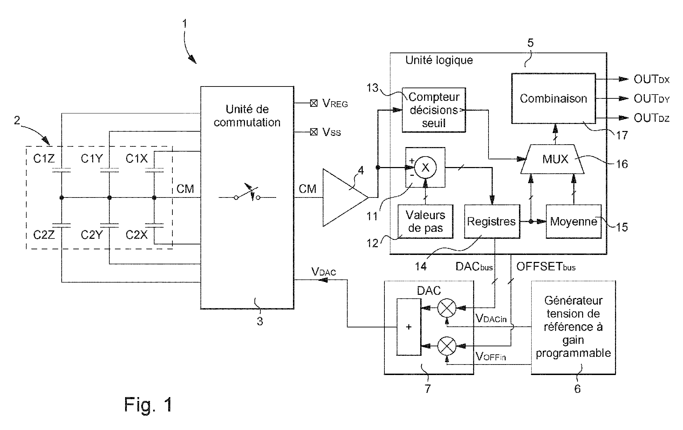

La figure 1 montre un schéma simplifié des différents composants du circuit électronique 1 d'interface d'un capteur capacitif 2 selon l'invention. Dans cette forme d'exécution, il est prévu de relier un capteur capacitif 2 triaxial du type MEMS à masse unique au circuit électronique 1, même s'il est tout à fait concevable également de connecter un capteur triaxial à trois masses mobiles ou un capteur uniaxe. Ce capteur capacitif est donc composé de trois paires de condensateurs C1X, C2X, C1Y, C2Y, C1Z et C2Z. Les deux condensateurs de chaque paire sont montés en différentiel. Une électrode commune CM des paires de condensateurs peut se déplacer sous l'action notamment d'une force entre deux électrodes fixes de chaque paire de condensateurs pour effectuer une mesure tenant compte des trois axes X, Y et Z.

Le circuit électronique 1 peut fournir des signaux numériques de mesure pour chaque axe, qui sont relatifs à un paramètre physique, tel qu'une accélération, une vitesse angulaire, une pression ou une force, en fonction du déplacement de l'électrode commune mobile. Dans le cas d'une mesure d'accélération, le circuit électronique peut être configuré pour fournir des signaux numériques de mesure entre des valeurs minimum et maximum d'accélération. Il peut être choisi par exemple de configurer le circuit électronique pour fournir des signaux numériques de mesure dans la gamme de -2g à +2g d'accélération. Une variation de tension de l'ordre de 3 à 20 mV peut être comptée pour 1 g d'accélération.

L'électrode commune mobile CM peut faire partie d'une armature du capteur maintenue élastiquement dans une position centrale au repos entre les deux électrodes fixes de chaque paire de condensateurs C1X, C2X, C1Y, C2Y, C1Z et C2Z. Le circuit électronique 1 peut être alimenté par une source de tension d'alimentation continue non représentée. Cette source de tension d'alimentation fournit à une première borne une tension régulée haute $V_{REG}$ et à une seconde borne une tension basse $V_{SS}$. La tension basse peut être définie à 0 V, alors que la tension régulée haute peut être fixée à 1.65 V par exemple. L'électrode fixe de chaque condensateur peut être polarisée dans une phase d'un cycle de mesure, soit à la tension haute $V_{REG}$, soit à la tension basse $V_{SS}$ dans un mode de fonctionnement du circuit électronique. De ce fait, comme les deux condensateurs C1X, C2X, C1Y, C2Y, C1Z et C2Z de chaque paire ont une valeur capacitive égale dans un mode de repos du capteur 2, la tension sur l'électrode commune CM est de préférence égale au repos à une tension intermédiaire $V_{REG}/2$ entre la tension régulée $V_{REG}$ et la tension basse Vss à 0 V.

Les signaux numériques de mesure fournis par le circuit électronique 1 sont proportionnels pour deux condensateurs C1 et C2 à (C1-C2)/(C1+C2). Une fois que les signaux numériques de mesure sont stabilisés à une mesure finale du paramètre physique au terme de chaque conversion, tout écoulement de charges sur les deux condensateurs de chaque paire s'annule. Ainsi le but du circuit électronique consiste à trouver une tension à appliquer sur chaque électrode fixe dans une phase d'égalisation des charges sur la base d'un précédent signal numérique, qui satisfait à $(V_{REG}-V_{DAC})\cdot C1 = (V_{DAC}-V_{SS})\cdot C2$. Ceci est atteint quand $V_{DAC} = (V_{REG}/2)\cdot(1 +(C1-C2)/(C1+C2))$.

Le circuit électronique 1 comprend un amplificateur à transfert de charges du type comparateur 4, qui est relié directement à l'électrode mobile CM des condensateurs par l'intermédiaire d'une unité de commutation 3. L'unité de commutation 3 reçoit les tensions $V_{REG}$, $V_{SS}$ et $V_{DAC}$ à appliquer aux électrodes du capteur selon les phases d'un cycle de mesure. La tension régulée $V_{REG}$ et la tension basse $V_{SS}$ sont appliquées aux électrodes fixes, alors que la tension $V_{DAC}$, d'un convertisseur numérique-analogique 7 en contre-réaction, est appliquée à toutes les électrodes. Dans chaque cycle de mesure, une alternance entre une phase, où toutes les électrodes reçoivent une tension $V_{DAC}$ d'une précédente mesure et une phase de polarisation des électrodes fixes entre $V_{REG}$ et $V_{SS}$ intervient.

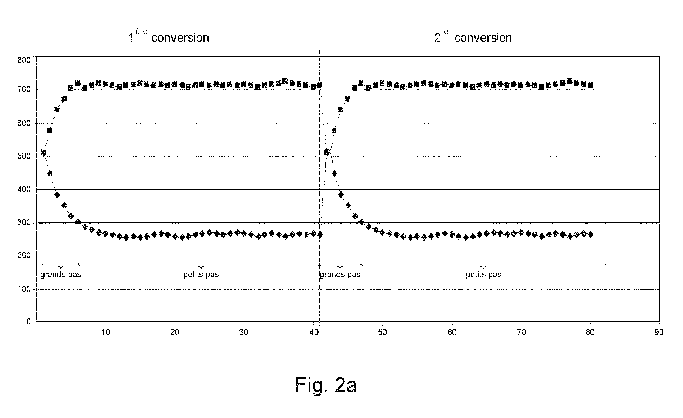

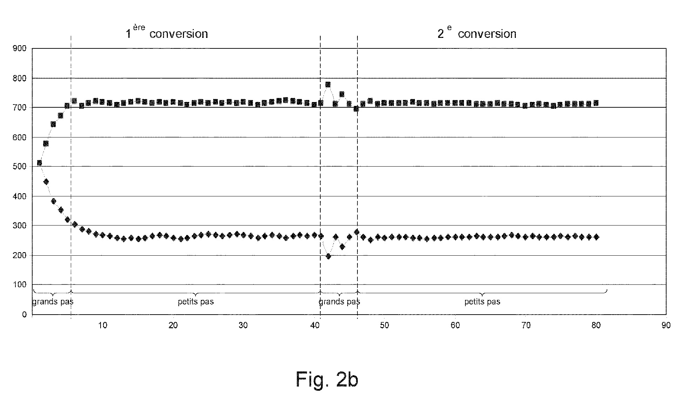

Pour comprendre comment les tensions sont appliquées aux électrodes durant chaque cycle de mesure et pour les trois axes de mesure, il est fait référence à la demande de brevet EP 2 343 507 A1, qui est incorporée ici par référence. A ce titre, toutes les tensions sont expliquées en référence à la figure 2 de cette demande de brevet, et décrites aux paragraphes 40 à 48. Dans chaque premier demi-cycle de mesure une polarisation positive successive des électrodes fixes pour chaque axe de mesure est effectuée, en alternance avec la tension $V_{DAC}$ fournie à toutes les électrodes et qui est relative à un premier signal numérique de mesure précédent de la polarisation positive pour chaque axe de mesure. La polarisation positive peut être une première polarisation des électrodes fixes. Dans chaque second demi-cycle de mesure une polarisation négative successive des électrodes fixes est effectuée, en alternance avec la tension $V_{DAC}$ fournie à toutes les électrodes et qui est relative à un second signal numérique de mesure précédent de la polarisation négative pour chaque axe de mesure. La polarisation négative peut être une seconde polarisation. La polarisation positive entre $V_{REG}$ et $V_{SS}$ est l'inverse de la polarisation négative.

Il est à noter qu'il peut également être envisagé d'effectuer les étapes de polarisation positive et de polarisation négative des électrodes du capteur, en alternance de la tension $V_{DAC}$ des premier et second signaux numériques pour chaque axe successivement.

Chaque cycle de mesure d'accélération compte 12 phases, dont 3 phases de polarisation positive pour chaque axe de mesure, et 3 phases de polarisation négative, pour un capteur triaxial, alors qu'uniquement 4 phases sont suffisantes pour un capteur uniaxe. De plus, plusieurs cycles de mesure successifs sont nécessaires pour obtenir les valeurs finales numériques de mesure pour chaque axe de chaque conversion comme expliqué ci-après. Pour chaque conversion, il peut être effectué par exemple 16, 32, 40 ou 64 cycles de mesure successifs. Cependant à la différence de la succession de cycles de mesure présentée dans cette demande de brevet, chaque conversion du procédé de mesure selon l'invention ne débute de préférence pas au milieu de la marge de mesure à $V_{REG}/2$. Chaque conversion débute en prenant en compte la précédente valeur numérique mémorisée d'une précédente conversion respectivement pour chaque axe de mesure et pour une polarisation positive et une polarisation négative.

L'amplificateur comparateur 4 est de conception très simple du type de celui décrit dans l'article intitulé "A 1 mV MOS Comparator" de la revue IEEE J. Solid-State Circuits, vol. SC-13. pp. 294-298 de juin 1978. Cet amplificateur comparateur 4 comprend généralement un condensateur en entrée relié à l'électrode commune CM, suivi d'étages amplificateurs pour fournir en sortie un signal de forme numérique en tout ou rien. Cet amplificateur à transfert de charges a un très haut gain. Le signal de sortie de l'amplificateur est à l'état "1" proche de la tension régulée $V_{REG}$ quand la tension sur l'électrode mobile CM augmente par l'accumulation de charges positives dans les cycles de mesure. Par contre, le signal de sortie de l'amplificateur passe à l'état "0" proche de la tension basse $V_{SS}$ quand la tension sur l'électrode mobile CM diminue par l'accumulation de charges négatives dans les cycles de mesure.

Le circuit électronique 1 comprend encore une unité logique 5, qui comprend des moyens de mémorisation, dans lesquels sont mémorisés notamment différents paramètres de configuration, et principalement l'algorithme de mesure du procédé selon l'invention. L'unité logique 5 du circuit électronique comprend encore un processeur non représenté, qui est cadencé par un signal d'horloge traditionnel, de manière à contrôler l'exécution de toutes les étapes nécessaires du procédé de mesure d'un paramètre physique, notamment d'une accélération.

L'unité logique 5 comprend encore au moins un compteur 13 relié au processeur, et plusieurs registres 14 pour stocker des signaux numériques sous forme de mots binaires de mesure pour chaque axe de mesure. Il est prévu deux registres non représentés par axe de mesure. Ainsi pour la mesure d'une accélération avec un capteur triaxial, l'unité logique 5 compte six registres pour les trois axes de mesure. Pour chaque axe, un premier registre reçoit un premier signal numérique de mesure provenant d'une polarisation définie positive (pol à "0") des électrodes fixes de la paire de condensateurs correspondante, alors qu'un second registre reçoit un second signal numérique de mesure provenant d'une polarisation définie négative (pol à "1") des électrodes fixes de la paire de condensateurs correspondante. La polarisation négative est simplement une polarisation inversée de la polarisation positive.

Lors de chaque cycle de mesure, le premier signal numérique et le second signal numérique pour chaque axe stocké dans un registre correspondant, est incrémenté ou décrémenté d'une certaine valeur numérique fonction d'un pas déterminé et programmé. Pour ce faire, l'unité logique 5 comprend un élément de multiplication 11, qui reçoit le signal de sortie de l'amplificateur comparateur 4, et une valeur numérique d'un élément 12 de fourniture d'une valeur de pas. Si la sortie de l'amplificateur comparateur 4 est à l'état haut "1", cela signifie une augmentation de tension sur l'électrode mobile CM. Dans ces conditions, l'élément de multiplication 11 multiplie la valeur numérique de pas par +1 pour pouvoir ajouter la valeur numérique de pas au précédent signal numérique stocké dans le registre correspondant 14. Par contre si la sortie de l'amplificateur comparateur 4 est à l'état bas "0", cela signifie une diminution de tension sur l'électrode mobile CM. Dans ces conditions, l'élément de multiplication 11 multiplie la valeur numérique de pas par -1 pour pouvoir soustraire la valeur numérique de pas au précédent signal numérique stocké dans le registre correspondant 14.

Dans une première série de cycles de mesure de chaque conversion, de grandes valeurs numériques programmées de pas sont fournies par l'élément 12 de fourniture d'une valeur de pas. Ces premières grandes valeurs numériques peuvent être programmées par exemple pour valoir 32 ou 64 ou une autre grande valeur sur une échelle de 0 à 1023 pour chaque mot binaire sur 10 bits. Chaque mot binaire peut être sur plus de 10 bits ou moins de bits en fonction de l'application prévue du circuit électronique avec le capteur capacitif. Ces grandes valeurs numériques peuvent être donc ajoutées ou soustraites à un précédent signal numérique stocké dans le registre correspondant. Pour les premiers cycles de mesure de chaque conversion, il peut être prévu d'effectuer durant 2 à 8 premiers cycles de mesure, l'ajout ou la soustraction d'une grande valeur de pas au précédent signal numérique d'un registre correspondant. A la suite par exemple de ces 2, 4, 6 ou 8 premiers cycles de mesure, une seconde série de cycles de mesure est effectuée jusqu'au terme de chaque conversion, dans laquelle une petite valeur numérique programmée de pas est ajoutée ou soustraite du signal numérique d'un registre correspondant 14. Ceci est effectué pour les 6 registres successivement. Cette petite valeur numérique de pas peut avantageusement être choisie pour valoir 1, voire 2 en fonction du bruit à tenir compte.

La durée de chaque conversion de mesure pour les trois axes de mesure peut être inférieure à 1'500 $\mu$s, si chaque phase est de durée de l'ordre de 2 $\mu$s ou inférieure. Bien entendu, cette durée dépend également du nombre d'échantillons prélevés pour chaque axe et chaque polarisation positive ou négative.

Pour chaque conversion de mesure, dans laquelle il peut être prévu 16, 32, 40 ou 64 cycles de mesure successifs, une moyenne de tous les signaux numériques successifs stockés dans un registre correspondant dans au moins une partie finale de la seconde série de cycles de mesure peut être effectuée. Au moins 8, 10, 12 ou plus d'échantillons de signaux numériques successifs stockés dans l'unité logique 5 dans les derniers cycles de mesure sont utilisés pour effectuer la moyenne. Cette moyenne est effectuée par l'intermédiaire d'un élément 15 d'exécution d'une moyenne relié aux registres 14. Une mémoire particulière lié à l'élément 15 à moyenne peut stocker tous les signaux numériques successifs d'un registre correspondant. Une telle moyenne des résultats de la seconde série de cycles de mesure peut bien entendu être effectuée, sauf s'il n'y a qu'une augmentation ou une diminution continuelle par petite valeur de pas du signal numérique d'un registre correspondant dans une grande partie des cycles de mesure.

L'unité logique 5 comprend encore le compteur de décisions 13, qui est utilisé pour détecter dans la seconde série de cycles de mesure de chaque conversion, si le signal de sortie de l'amplificateur comparateur 4 est continuellement à l'état "1" ou à l'état "0" dans chaque cycle de mesure successif. Si le nombre compté de "1" ou "0" à la suite par le compteur 13 excède un seuil prédéterminé, le compteur 13 fournit un signal de commande à un multiplexeur 16 pour la fourniture à la sortie du multiplexeur du dernier signal numérique de mesure stocké dans le registre correspondant. Ce seuil peut être défini en tenant compte du nombre de cycles de la seconde série de cycles de mesure. Dans le cas de plus de 50 cycles dans la seconde série de cycles de mesure, le seuil du compteur de décisions 13 peut être défini par exemple à 8 cycles ou 30 cycles ou 40 cycles ou à une autre valeur.

Dans le cas où le nombre compté par le compteur de décisions n'excède pas le seuil, le multiplexeur 16 fournit en sortie la moyenne des différents signaux numériques stockés dans la seconde série de cycles de mesure, qui est fournie par l'élément 15 à moyenne. Au terme de chaque conversion, l'unité logique 5 fournit, par combinaison ou addition de deux registres par axe de mesure dans un élément de combinaison 17, relié au multiplexeur 16, un signal numérique de sortie par $OUT_{DX}$, $OUT_{DY}$, $OUT_{DZ}$. Dans ces signaux de sortie combinés pour chaque axe, tout écart de tension (offset) a été supprimé.

Il est à noter qu'au terme de chaque conversion, soit le dernier signal numérique de chaque registre, soit la moyenne mémorisée de différents signaux numériques dans la seconde série précédente de cycles de mesure, est utilisé pour une nouvelle conversion. Cela permet avantageusement de bénéficier des précédentes variations de valeurs de précédentes conversions tout en mémorisant l'offset précédent. Dans ces conditions, il n'est plus forcément nécessaire d'effectuer pour toutes les conversions subséquentes plusieurs premiers cycles d'ajout ou de retrait de grandes valeurs de pas. Avec la seconde série de cycles de mesure par l'ajout ou le retrait d'une petite valeur de pas, cela permet de réduire les effets du bruit.

Il est encore à noter qu'au début de chaque conversion de mesure dans la première série de cycles de mesure, la grande valeur de pas à ajouter ou à soustraire au signal numérique mémorisé dans le registre correspondant, peut être modifié dans une même conversion ou d'une conversion à une autre conversion. La grande valeur de pas peut être augmentée ou diminuée progressivement depuis le début de la première série de cycles de mesure ou le nombre de cycles de mesure de la première série peut être plus ou moins grand d'une conversion à une autre conversion.

Chaque signal numérique de mesure ou mot binaire DACbus stocké dans les registres 14 est fourni successivement dans chaque cycle de mesure au convertisseur numérique-analogique DAC 7 de manière à convertir notamment chaque mot binaire DACbus en une tension de sortie $V_{DAC}$. Comme précédemment expliqué, cette tension de sortie du DAC permet de décharger dans une des phases de chaque cycle de mesure tous les condensateurs C1X, C2X, C1 Y, C2Y, C1Z, C2Z et CM à une valeur de tension dépendant du mot binaire DACbus d'un axe particulier. Le mot binaire DACbus est multiplié dans un premier multiplicateur dans le convertisseur numérique-analogique 7 par une tension de référence $V_{DACin}$, qui provient d'un générateur de tension de référence à gain programmable 6. Cette tension de référence peut être fournie au moyen d'un diviseur résistif connecté entre la tension régulée $V_{REG}$ et la masse $V_{SS}$.

L'unité logique 5 fournit également un mot binaire d'ajustage OFFSETbus (10 bits) d'un écart de tension relatif au capteur MEMS en entrée. Ce mot binaire d'ajustage OFFSETbus est multiplié dans un second multiplicateur dans le convertisseur numérique-analogique 7 avec une tension d'ajustage $V_{OFFin}$, qui provient du générateur de tension de référence à gain programmable 6. Cette tension d'ajustage $V_{OFFin}$ peut également être obtenue au moyen d'un diviseur résistif connecté entre la tension régulée $V_{REG}$ et la masse $V_{SS}$. Une addition des tensions de sortie des deux multiplicateurs du convertisseur 7 est ensuite effectuée de manière que le convertisseur numérique-analogique fournisse en sortie la tension $V_{DAC}$. Comme on le verra ci-après, l'écart de tension lié au capteur MEMS ne dépend pas de la polarisation appliquée aux électrodes fixes des paires de condensateurs. Une étape préliminaire de calibrage pour corriger cet écart de tension (offset) du capteur MEMS peut être effectuée une fois pour toute avant la mesure du paramètre physique du circuit électronique 1.

Comme les mots binaires DACbus et OFFSETbus peuvent être sur 10 bits de 0 à 1023, on peut exprimer la tension de sortie $V_{DAC}$ provenant d'une polarisation positive (polarité "0") des électrodes fixes d'une part et d'une polarisation négative (polarité "1 ") des électrodes fixes d'autre part. Ces deux équations eq(0) et eq(1) des deux tensions $V_{DAC}$ sont exprimées comme suit :

$$eq(0) : V_{DAC}(0) = V_{REG}/2 + V_{DACoffset} + (DACbus(0)-512) \cdot K_{DAC} \cdot V_{REG} + (OFFSETbus-512) \cdot K_{OFF} \cdot V_{REG}$$

$$eq(1) : V_{DAC}(1) = V_{REG}/2 + V_{DACoffset} - (DACbus(1)-512) \cdot K_{DAC} \cdot V_{REG} - (OFFSETbus-512) \cdot K_{OFF} \cdot V_{REG}$$

$K_{DAC}$ est un facteur qui définit le gain du système. Ce gain peut être programmable par exemple en générant une tension $V_{DACin}$ qui provient d'un diviseur résistif du générateur de tension de référence 6. $K_{OFF}$ est un facteur, qui définit le gain de la circuiterie d'ajustage de l'écart de tension (offset) du capteur MEMS. Ce gain peut être adapté selon la plage d'ajustage désirée par exemple en générant une tension $V_{OFFin}$ qui provient d'un autre diviseur résistif du générateur de tension de référence 6. DACbus(0) définit le mot binaire sur 10 bits, qui provient d'un premier registre de l'unité logique 5, qui est appliqué au convertisseur DAC 7 durant les phases de la polarisation positive. Ce mot binaire est défini de 0 à 1023. DACbus(1) définit le mot binaire sur 10 bits, qui provient d'un second registre de l'unité logique 5, qui est appliqué au convertisseur DAC 7 durant les phases de la polarisation négative. Ce mot binaire est défini de 0 à 1023. OFFSETbus définit le mot binaire d'ajustage sur 10 bits, qui est appliqué au convertisseur DAC 7 pour réaliser la correction de l'écart de tension (offset) lié au capteur MEMS. $V_{DACoffset}$ représente l'écart parasite de tension (offset) du convertisseur DAC 7, ce qu'on veut notamment supprimer. Cet écart parasite de tension englobe tout l'écart de tension lié au circuit électronique (amplificateur, convertisseur,...), et peut aussi représenter le bruit à basse fréquence ("flicker noise" en terminologie anglaise).

Il est encore à noter que DACbus(0) peut être différent de DACbus(1) si une accélération est mesurée, car ces mots binaires dépendent de l'état de la polarisation appliquée aux électrodes fixes. Par contre OFFSETbus ne dépend absolument pas de la polarisation appliquée aux électrodes fixes. Ainsi OFFSETbus est choisi de manière définitive après l'étape préliminaire de calibrage du capteur MEMS lié au circuit électronique comme indiqué ci-devant. Ce mot binaire d'ajustage peut être mémorisé dans les moyens de mémorisation de l'unité logique 5. Dans le cas où le capteur MEMS a besoin d'une variation de tension $V_{MEMS}$ autour de $V_{REG}/2$ pour réaliser l'équilibre des charges, les équations eq(0) et eq(1) prennent la forme suivante :

$$eq(0) : V_{REG}/2 + V_{MEMS} = V_{REG}/2 + V_{DACoffset} + (DACbus(0)-512) \cdot K_{DAC} \cdot V_{REG} + (OFFSETbus-512) \cdot K_{OFF} \cdot V_{REG}$$

$$eq(1) : V_{REG}/2 - V_{MEMS} = V_{REG}/2 + V_{DACoffset} - (DACbus(1)-512) \cdot K_{DAC} \cdot V_{REG} - (OFFSETbus-512) \cdot K_{OFF} \cdot V_{REG}$$

Si la capacité C1X est plus grande que la capacité C2X par exemple, l'équilibre des charges se fait à une tension supérieure à $V_{REG}/2$ pour la polarisation positive et à une tension inférieure à $V_{REG}/2$ pour une polarisation négative. Si on effectue la soustraction de ces deux équations eq(0) et eq(1), cela donne l'équation eq(2) suivante :

$$eq(2) : 2 \cdot V_{MEMS} = (DACbus(0)+DACbus(1)-1024) \cdot K_{DAC} \cdot V_{REG} + 2 \cdot (OFFSETbus-512) \cdot K_{OFF} \cdot V_{REG}$$

DACbus(0)+DACbus(1)-1024 est proportionnel à $V_{MEMS}$, qui est également proportionnelle à l'accélération. Le terme $V_{DACoffset}$ a disparu de l'équation eq(2), ce qui est le but final. Le gain du système dépend donc du choix de $K_{DAC}$. L'écart de tension du capteur MEMS peut aussi toujours être supprimé au moyen d'une bonne sélection du mot binaire OFFSETbus.

Pour mieux représenter l'évolution des signaux numériques pour une ou deux conversions successives, on peut se référer aux figures 2a, 2b, 3a, 3b et 4 relatives au procédé de mesure selon l'invention.

A la figure 2a, il est représenté deux conversions de mesure successives notamment dans le cas d'une mesure pour un capteur uniaxe. Cependant des graphes identiques peuvent aussi être représentés dans le cas d'une mesure par un capteur triaxial. Sur l'axe x, il est défini le nombre d'échantillons prélevés pour la mesure suite à la polarisation positive et la mesure suite à la polarisation négative. Un échantillon pour chaque signal numérique est obtenu dans un cycle de mesure. Sur l'axe y, il est défini le niveau de chaque signal numérique.

Les deux conversions de mesure sont représentées de manière simplifiée dans le cas où il n'y a pas d'accélération à mesurer par le capteur, mais par contre où il y a un fort offset du convertisseur DAC à tenir compte. Au début de chaque conversion, les mots binaires du registre de la polarisation positive et du registre de la polarisation négative sont toujours réinitialisés au milieu de la marge de mesure, c'est-à-dire à 512 pour une marge numérique de 0 à 1023. Le signal numérique de la polarisation négative augmente dans chaque conversion depuis l'initialisation à 512, alors que le signal numérique de la polarisation positive diminue dans chaque conversion depuis l'initialisation à 512. On remarque que les valeurs du signal numérique de la polarisation positive sont espacées des valeurs du signal numérique de la polarisation négative de manière à compenser l'offset du circuit électronique par combinaison des deux signaux numériques.

On observe bien sur cette figure 2a, que chaque conversion de mesure débute par une première série de cycles de mesure avec une grande valeur de pas ajoutée ou soustraite du signal numérique précédemment mémorisé. Au terme de cette première série de cycles de mesure, par exemple après 6 cycles de mesure, une seconde série de cycles de mesure débute. Dans cette seconde série, une petite valeur de pas est ajoutée ou soustraite au précédent signal numérique mémorisé dans le registre correspondant. Au terme de chaque conversion, une réinitialisation à 512 intervient pour une prochaine conversion après avoir fourni les signaux numériques combinés en sortie de l'unité logique à leur dernière valeur. Cette manière d'opérer en réinitialisant à chaque conversion au milieu de la marge de mesure peut s'avérer désavantageuse si de grands changements d'accélération surviennent d'une conversion à une autre conversion.

A la figure 2b, il est aussi représenté deux conversions de mesure successives notamment dans le cas d'une mesure pour un capteur uniaxe. Sur l'axe x, il est défini le nombre d'échantillons prélevés pour la mesure suite à la polarisation positive et la mesure suite à la polarisation négative. Un échantillon pour chaque signal numérique est obtenu dans un cycle de mesure. Sur l'axe y, il est défini le niveau de chaque signal numérique.

Les deux conversions de mesure sont représentées de manière simplifiée dans le cas où il n'y a pas d'accélération à mesurer par le capteur, mais par contre où il y a un fort offset du convertisseur DAC à tenir compte. La première conversion, qui débute à la valeur initiale de 512, est identique à la première conversion de la figure 2a. Par contre pour la seconde conversion, le dernier signal numérique du registre correspondant est utilisé pour débuter la première série de cycles de mesure. Il peut aussi être utilisé dans ce cas de figure, la moyenne des signaux numériques successivement mémorisés dans le registre correspondant dans au moins une grande partie de la seconde série de cycles de mesure, pour débuter la première série de cycles de mesure de la seconde conversion. Ainsi, chaque signal numérique représenté reste proche de sa valeur d'état stable, mais la première série de cycles de mesure est tout de même effectuée avec une grande valeur de pas.

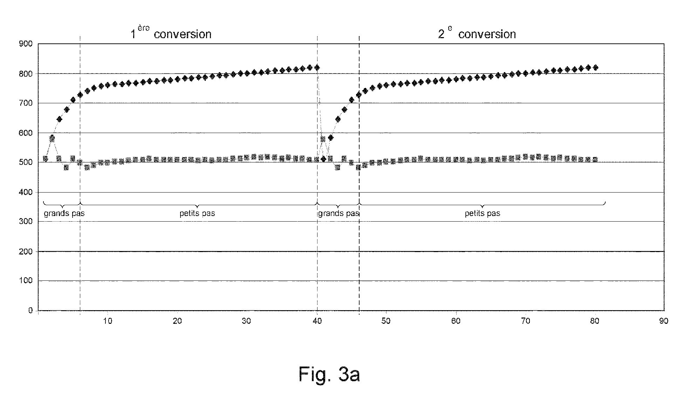

A la figure 3a, il est représenté deux conversions de mesure successives notamment dans le cas d'une mesure pour un capteur uniaxe. Sur l'axe x, il est défini le nombre d'échantillons prélevés pour la mesure suite à la polarisation positive et la mesure suite à la polarisation négative. Un échantillon pour chaque signal numérique est obtenu dans un cycle de mesure. Sur l'axe y, il est défini le niveau de chaque signal numérique.

Les deux conversions de mesure sont représentées de manière simplifiée dans le cas où il y a une grande accélération à mesurer par le capteur et un grand offset du convertisseur DAC. La grande accélération à mesurer doit en principe faire tendre un des signaux numériques vers une valeur maximum de 1000. Au début de chaque conversion, les mots binaires du registre de la polarisation positive et du registre de la polarisation négative sont toujours réinitialisés au milieu de la marge de mesure, c'est-à-dire à 512 pour une marge numérique de 0 à 1023.

Comme représenté, le signal numérique de la polarisation négative a tendance à rester proche du milieu de la marge de mesure vers 500, alors que le signal numérique de la polarisation positive augmente pour se rapprocher de la valeur maximum espérée. Cependant on remarque que comme une initialisation au milieu de la marge de mesure est intervenue au début de chaque conversion, le signal numérique de la polarisation positive n'arrive jamais à atteindre la valeur maximum de la cible d'accélération souhaitée. Il faudrait dans ce cas augmenter le nombre de cycles dans la première série de cycles de mesure ou augmenter la grande valeur de pas à ajouter dans les premiers cycles de mesure, qui a tendance à générer plus de bruit. La seconde série de cycles de mesure avec une petite valeur de pas ajoutée ou soustraite, est encore nécessaire pour réduire le bruit en sortie. Une grande variation due à l'offset et à une forte accélération mène à un trop grand changement notamment dans le signal numérique de la polarisation positive.

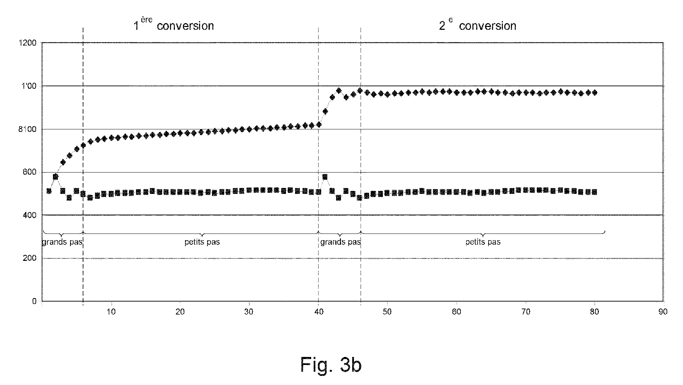

A la figure 3b, il est représenté deux conversions de mesure successives notamment dans le cas d'une mesure pour un capteur uniaxe. Sur l'axe x, il est défini le nombre d'échantillons prélevés pour la mesure suite à la polarisation positive et la mesure suite à la polarisation négative. Un échantillon pour chaque signal numérique est obtenu dans un cycle de mesure. Sur l'axe y, il est défini le niveau de chaque signal numérique.

Les deux conversions de mesure sont représentées de manière simplifiée dans le cas où il y a une grande accélération à mesurer par le capteur et un grand offset du convertisseur DAC. La première conversion, qui débute à la valeur initiale de 512, est identique à la première conversion de la figure 3a. Par contre pour la seconde conversion, le dernier mot binaire du signal numérique du registre correspondant est utilisé pour débuter la première série de cycles de mesure.

Comme pour la première conversion, le signal numérique de la polarisation positive n'atteint jamais la valeur cible souhaitée de 1000, à chaque cycle de mesure dans la seconde série de cycles de mesure, une augmentation continuelle intervient dans chaque cycle. De ce fait, c'est bien le dernier mot binaire, qui est utilisé pour débuter la seconde conversion. Avec la seconde conversion, on remarque qu'en partant de la précédente valeur du signal numérique de la polarisation positive, le dernier mot binaire dudit signal numérique s'approche de la valeur cible d'accélération vers 1000. La réutilisation de la précédente valeur du signal numérique permet avec le même algorithme de supprimer de manière plus efficace l'offset grâce à la mémorisation. Cela diminue aussi le nombre de pas requis pour atteindre le bonne convergence et/ou réduire le bruit sur la sortie finale calculée.

En partant de la précédente valeur du signal numérique pour la seconde conversion, il peut être calculé la moyenne d'au moins une partie des signaux numériques successivement mémorisés dans le registre correspondant dans la seconde série de cycles de mesure. Cette moyenne peut par la suite être mémorisée dans le registre du signal numérique de la polarisation positive, pour débuter une troisième conversion non représentée.

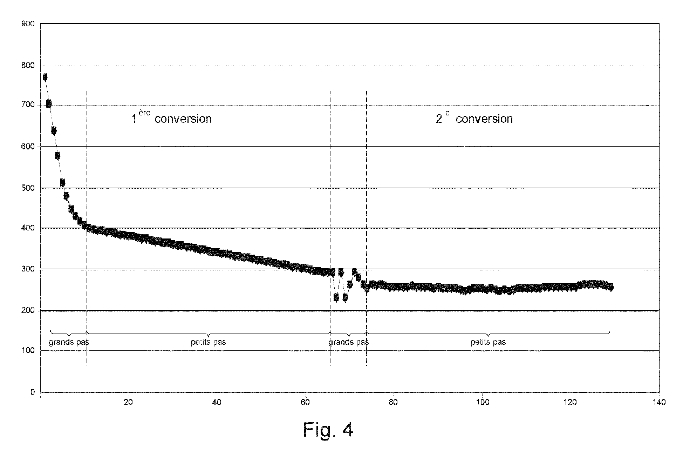

A la figure 4, il est représenté à titre d'exemple un signal numérique d'une polarisation négative avec un changement maximum d'accélération entre deux conversions successives de mesure en considérant un offset nul pour le procédé de mesure selon l'invention. La première conversion débute à une valeur maximum du signal numérique de la polarisation négative, c'est-à-dire proche de 800. La valeur cible attendue est proche 250, ce qui représente un grand changement d'accélération. Comme représenté à la figure 3a, le signal numérique de cette polarisation négative n'atteint pas la valeur cible de 250 au terme de la première conversion. Le dernier signal numérique mémorisé dans le registre correspondant est pris en compte pour débuter la seconde conversion. Dans cette seconde conversion, on remarque la valeur cible de 250 est atteinte au terme de la seconde conversion. Une moyenne d'au moins une partie des signaux numériques successivement mémorisés dans le registre correspondant dans la seconde série de cycles de mesure, peut être effectuée. Cette moyenne peut par la suite être mémorisée dans le registre du signal numérique de la polarisation négative, pour débuter une troisième conversion non représentée.

A partir de la description qui vient d'être faite, de multiples variantes de réalisation du procédé de mesure d'un paramètre physique et du circuit électronique d'interface du capteur capacitif pour sa mise en oeuvre peuvent être conçues par l'homme du métier sans sortir du cadre de l'invention définie par les revendications. Il peut être envisagé de modifier la durée de chaque phase l'une par rapport à l'autre ou la durée de chaque cycle durant les opérations de mesure du paramètre physique, ainsi que le nombre de cycles de mesure successifs pour chaque conversion de mesure. Il peut être prévu de modifier l'ordre des polarisations positive et négative dans chaque cycle de mesure. Il peut aussi être placé dans chaque cycle de mesure au moins deux phases supplémentaires d'un test de fonctionnalité du circuit électronique.

## Revendications

**1.** Procédé de mesure d'un paramètre physique au moyen d'un circuit électronique (1) d'interface relié à un capteur capacitif (2), qui comprend au moins deux condensateurs (C1X, C2X) montés en différentiel, dont une électrode commune (CM) est susceptible de se déplacer par rapport à chaque électrode fixe des deux condensateurs pour modifier la valeur capacitive de chaque condensateur lors de la mesure du paramètre physique, ledit circuit électronique comprenant un amplificateur à transfert de charges (4), qui est connecté à l'électrode commune (CM) par l'intermédiaire d'une unité de commutation (3), une unité logique (5) reliée à la sortie de l'amplificateur pour un traitement numérique de l'information fournie par l'amplificateur et la fourniture de signaux numériques de mesure, et un convertisseur numérique-analogique (7) susceptible de fournir une tension de mesure ($V_{DAC}$) aux électrodes par l'intermédiaire de l'unité de commutation (3), la tension de mesure étant définie sur la base d'une conversion d'un mot binaire (DACbus) définissant au moins un des signaux numériques de mesure,
le procédé comprenant plusieurs cycles successifs de mesure pour une conversion de mesure, où chaque cycle successif de mesure comprend des étapes :

a) de polariser les électrodes des condensateurs (C1X, C2X, CM) par l'intermédiaire de l'unité de commutation (3) avec une tension de mesure ($V_{DAC}$) fournie par le convertisseur numérique-analogique (7) sur la base d'un premier signal numérique de mesure d'un précédent cycle ou d'un premier mot binaire initial fourni par l'unité logique (5), le premier signal numérique dépendant d'une première polarisation des électrodes fixes des condensateurs,

b) de relier les électrodes fixes des condensateurs (C1X, C2) par l'intermédiaire de l'unité de commutation (3), chacune respectivement aux bornes d'une source de tension d'alimentation ($V_{REG}$, $V_{SS}$) pour une première polarisation des électrodes fixes,

c) de polariser les électrodes des condensateurs (C1X, C2X, CM) par l'intermédiaire de l'unité de commutation (3) avec une tension de mesure ($V_{DAC}$) fournie par le convertisseur numérique-analogique (7) sur la base d'un second signal numérique de mesure d'un précédent cycle ou d'un second mot binaire initial fourni par l'unité logique (5), le second signal numérique dépendant d'une seconde polarisation inverse de la première polarisation des électrodes fixes des condensateurs,

d) de relier les électrodes fixes des condensateurs (C1X, C2) par l'intermédiaire de l'unité de commutation (3), chacune respectivement aux bornes d'une source de tension d'alimentation ($V_{REG}$, $V_{SS}$) pour une seconde polarisation des électrodes fixes, qui est l'inverse de la première polarisation, **caractérisé en ce que** le procédé débute chaque conversion par une première série de cycles successifs de mesure, dans lesquels les premier et second signaux numériques sont adaptés dans l'unité logique (5) à chaque cycle de mesure par l'addition ou la soustraction d'une première valeur de pas déterminée et supérieure à 2 sur la base de l'information fournie par l'amplificateur à transfert de charges (4), et par une seconde série de cycles successifs de mesure à la suite de la première série de cycles de mesure, dans lesquels les premier et second signaux numériques sont adaptés dans l'unité logique (5) à chaque cycle de mesure par l'addition ou la soustraction d'une seconde valeur de pas déterminée égale à 1 ou 2, jusqu'au terme de la conversion de mesure.

**2.** Procédé de mesure selon la revendication 1, pour lequel l'unité logique (5) comprend un premier registre pour mémoriser le premier signal numérique de mesure sur 10 bits, et un second registre pour mémoriser le second signal numérique de mesure sur 10 bits, **caractérisé en ce que** chaque conversion de mesure débute sur la base d'une valeur numérique finale de chaque signal numérique mémorisé dans le premier registre et le second registre (14) d'une précédente conversion.

**3.** Procédé de mesure selon l'une des revendications précédentes, **caractérisé en ce qu'**une moyenne des signaux numériques successivement mémorisés dans l'unité logique (5) dans au moins une partie finale des cycles successifs de mesure de la seconde série de cycles de mesure, est effectuée pour mémoriser la moyenne de chaque signal numérique comme valeur numérique finale dans le registre correspondant à fournir pour débuter une conversion subséquente.

**4.** Procédé de mesure selon l'une des revendications 1 et 2, pour lequel l'unité logique (5) comprend un compteur de décisions (13) susceptibles de compter ou décompter successivement en fonction de l'état de la sortie de l'amplificateur à transfert de charges (4) à chaque cycle de mesure dans la seconde série de cycles successifs de mesure, afin de détecter une augmentation continuelle ou une diminution continuelle de chaque signal numérique, **caractérisé en ce que** dans la seconde série de cycles de mesure, il est effectué une sélection de la dernière valeur numérique stockée de chaque signal numérique comme valeur numérique finale au terme de la conversion à fournir pour une conversion subséquente, si le compteur de décisions (13) a compté ou décompté dans des cycles successifs de mesure un nombre d'états identiques de la sortie de l'amplificateur à transfert de charges (4) supérieur à un seuil prédéterminé.

**5.** Procédé de mesure selon l'une des revendications précédentes, pour lequel le capteur capacitif est du type triaxial avec trois paires de condensateurs (C1X, C2X, C1Y, C2Y, C1Z, C2Z) montés en différentiel avec une électrode commune (CM) par paire ou pour toutes les paires et deux électrodes fixes pour chaque paire, et l'unité logique (5) du circuit électronique est en mesure de fournir des premier et second signaux numériques de mesure pour chaque axe de mesure X, Y et Z, **caractérisé en ce que** le procédé comprend 12 phases successives par cycle de mesure, qui consistent à répéter successivement pendant les six premières phases, les étapes a) et b) pour chaque axe X, Y, Z avec le premier signal numérique correspondant à l'axe sélectionné, et à répéter successivement pendant les six dernières phases, les étapes c) et d) pour chaque axe X, Y, Z avec le second signal numérique correspondant à l'axe sélectionné.

**6.** Procédé de mesure selon l'une des revendications précédentes, **caractérisé en ce qu'**il est effectué 16, 32, 40 ou 64 cycles de mesure dans chaque conversion de mesure, et **en ce que** la première série de cycles successifs de mesure comprend entre 2 et 8 cycles de mesure avec une première valeur de pas égale à 32 ou 64 sur une échelle de 0 à 1023 pour chaque mot binaire sur 10 bits des signaux numériques.

**7.** Procédé de mesure selon la revendication 4, **caractérisé en ce que** le compteur de décisions (13) compte ou décompte un nombre d'états successifs identiques de la sortie de l'amplificateur à transfert de charges (4) supérieur à un seuil égal à 8, pour sélectionner la dernière valeur numérique stockée de chaque signal numérique comme valeur numérique finale

**8.** Circuit électronique (1) d'interface d'un capteur capacitif, qui comprend une paire de condensateurs (C1X, C2X) montés en différentiel, pour la mise en oeuvre du procédé de mesure selon l'une des revendications précédentes, le circuit électronique comprenant un amplificateur à transfert de charges (4) connecté à l'électrode commune (CM) par l'intermédiaire d'une unité de commutation (3), une unité logique (5) reliée à la sortie de l'amplificateur pour un traitement numérique de l'information fournie par l'amplificateur et la fourniture de premier et second signaux numériques de mesure dépendant respectivement d'une première polarisation des électrodes fixes des condensateurs et d'une seconde polarisation inverse de la première polarisation, et un convertisseur numérique-analogique (7) susceptible de fournir une tension de mesure ($V_{DAC}$) aux électrodes par l'intermédiaire de l'unité de commutation (3), la tension de mesure étant définie sur la base d'une conversion du mot binaire (DACbus) relatif au premier signal numérique stocké dans un premier registre de l'unité logique (5) ou au second signal numérique de mesure stocké dans un second registre de l'unité logique (5), **caractérisé en ce que** l'unité logique (5) comprend un élément (15) d'exécution d'une moyenne relié aux registres (14), l'élément (15) étant destiné à effectuer une moyenne des premiers signaux numériques successifs et une moyenne des seconds signaux numériques successifs dans au moins une partie de la seconde série de cycles de mesure d'une conversion, et un compteur de décisions (13) susceptible de compter ou décompter en fonction de l'état de la sortie de l'amplificateur à transfert de charges (4) pour chaque cycle de mesure d'une conversion, le compteur de décisions étant destiné à commander la sélection de la dernière valeur numérique du premier signal numérique et du second signal numérique au terme d'une conversion, si le compte ou le décompte d'états identiques successifs dépasse un seuil prédéterminé, ou la sélection de la moyenne des premiers signaux numériques et la moyenne des seconds signaux numériques à mémoriser dans les registres si le seuil de comptage ou de décomptage du compteur de décisions (13) n'est pas dépassé, pour une conversion subséquente.

9. Circuit électronique (1) selon la revendication 8, en tant qu'interface d'un capteur capacitif triaxial, qui comprend trois paires de condensateurs (C1X, C2X, C1Y, C2Y, C1Z, C2Z) montés en différentiel, **caractérisé en ce qu'**il comprend un unique amplificateur à transfert de charge (4) pour la mesure selon les trois axes X, Y, Z de mesure du capteur, l'amplificateur étant capable de fournir une information du type numérique à l'unité logique (5) pour permettre au compteur de décisions (13) d'effectuer un comptage ou un décomptage en fonction de l'état de la sortie de l'amplificateur à transfert de charges (4) dans chaque cycle successif de mesure d'une conversion, et **en ce que** l'unité logique (5) fournit des premier et second signaux numériques de mesure pour chaque axe de mesure X, Y, Z.

10. Circuit électronique (1) selon la revendication 9, **caractérisé en ce que** l'unité logique (5) comprend six registres pour mémoriser les premier et second signaux numériques de mesure de chaque axe, chaque registre étant défini sur 10 bits.

11. Circuit électronique (1) selon l'une des revendications 8 à 10, **caractérisé en ce qu'**il comprend un multiplexeur (16) commandé par un signal de commande du compteur de décisions (13), de manière à fournir en sortie soit le dernier signal numérique de chaque registre, s'il y a un dépassement du seuil prédéterminé suite au comptage ou décomptage dans le compteur de décisions (13), soit la moyenne des premiers et seconds signaux numériques successifs de chaque axe dans la seconde série de cycles de mesure, si le seuil prédéterminé n'est pas dépassé, et un élément (17) de combinaison des premier et second signaux numériques de chaque axe reçus du multiplexeur (16), afin de fournir des signaux numériques de sortie de chaque axe ($OUT_{DX}$, $OUT_{DY}$, $OUT_{DZ}$).

**Patentansprüche**

1. Verfahren zum Messen eines physikalischen Parameters mittels eines elektronischen Schnittstellen-Schaltkreises (1), der an einen kapazitiven Aufnehmer (2) angeschlossen ist, der zumindest zwei in Differentialanordnung geschaltete Kondensatoren (C1X, C2X) umfasst, deren eine gemeinsame Elektrode (CM) gegenüber jeder der feststehenden Elektroden der zwei Kondensatoren verlagerbar ist, um den Kapazitätswert jedes Kondensators bei der Messung des physikalischen Parameters zu verändern, wobei der elektronische Schaltkreis einen Ladungsverschiebungsverstärker (4), der an die gemeinsame Elektrode (CM) über eine Umschalteinheit (3) angeschlossen ist, eine Logikeinheit (5), die mit dem Ausgang des Verstärkers zur digitalen Verarbeitung der durch den Verstärker gelieferten Informationen und zur Bereitstellung digitaler Messsignale verbunden ist, und einen Digital-Analog Wandler (7) umfasst, der geeignet ist, über die Umschalteinheit (3) eine Messspannung ($V_{DAC}$) an die Elektroden zu liefern, wobei die Messspannung auf der Basis einer Konversion eines Binärworts (DACbus) definiert ist, welches zumindest eines der digitalen Messsignale beschreibt, wobei das Verfahren mehrere aufeinanderfolgende Messzyklen für eine Messumsetzung umfasst, wobei jeder der aufeinanderfolgenden Messzyklen die Schritte umfasst:

a) Vorspannen der Elektroden der Kondensatoren (C1X, C2X, CM) über die Umschalteinheit (3) mit einer Messspannung ($V_{DAC}$), die von dem Digital-Analog Wandler (7) auf der Basis eines ersten digitalen Messsignals eines vorhergehenden Zyklus oder eines initialen ersten, von der Logikeinheit (5) gelieferten Binärwortes geliefert wird, wobei das erste digitale Signal von einer ersten Vorspannung der feststehenden Elektroden der Kondensatoren abhängt,

b) Verbinden jeweils jeder der feststehenden Elektroden der Kondensatoren (C1X, C2X) über die Umschalteinheit (3) mit den Anschlüssen einer Speisespannungsquelle ($V_{REG}$, $V_{SS}$) für eine erste Vorspannung der feststehenden Elektroden,

c) Vorspannen der Elektroden der Kondensatoren (C1X, C2X, CM) über die Umschalteinheit (3) mit einer Messspannung ($V_{DAC}$), die von dem Digital-Analog Wandler (7) auf der Basis eines zweiten digitalen Messsignals eines vorhergehenden Zyklus oder eines zweiten initialen, von der Logikeinheit (5) gelieferten Binärwortes geliefert wird, wobei das zweite digitale Signal von einer zweiten, gegenüber der ersten Vorspannung umgekehrten Vorspannung der feststehenden Elektroden der Kondensatoren abhängt,

d) Verbinden jeweils jeder der feststehenden Elektroden der Kondensatoren (C1X, C2X) über die Umschalteinheit (3) mit den Anschlüssen einer Speisespannungsquelle ($V_{REG}$, $V_{SS}$) für eine zweite Vorspannung der feststehenden Elektroden, die gegenüber der ersten Vorspannung umgekehrt ist,

**dadurch gekennzeichnet, dass** das Verfahren eine jede Umsetzung mit einer ersten Folge aufeinanderfolgender Messzyklen beginnt, in denen die ersten und zweiten digitalen Signale in der Logikeinheit (5) an einen jeden Messzyklus auf Basis der Information, die von dem Ladungsverschiebungsverstärker (4) geliefert wird, durch Addition oder Subtraktion eines ersten festgelegten Schrittwertes größer als 2 angepasst werden, und durch eine zweite Folge aufeinanderfolgender Messzyklen im Anschluss an die erste Folge von Messzyklen, in denen die ersten und zweiten digitalen Signale in der logischen Einheit (5) bis zur Beendigung der Messumsetzung an einen jeden Messzyklus durch Addition oder Subtraktion eines zweiten Schrittwerts, der auf die Werte 1 oder 2 festgelegt ist, angepasst werden.

2. Messverfahren nach Anspruch 1, bei dem die Logikeinheit (5) ein erstes Register umfasst, um das erste digitale Messsignal mit 10 Bits zu speichern, und ein zweites Register, um das zweite digitale Messsignal mit 10 Bits zu speichern, **dadurch gekennzeichnet, dass** jede Messumsetzung auf der Basis eines digitalen Endwerts eines jeden in dem ersten Register und dem zweiten Register (14) von einer vorhergehenden Umsetzung gespeicherten digitalen Signals beginnt.

3. Messverfahren nach einem der vorhergehenden Ansprüche, **dadurch gekennzeichnet, dass** ein Mittelwert der zumindest während eines Schlussteils aufeinanderfolgender Messzyklen der zweiten Folge von Messzyklen nacheinander in der Logikeinheit (5) gespeicherten digitalen Signale gebildet wird, um den Mittelwert jedes digitalen Signals als digitalen Endwert in dem zugehörigen Register zu speichern, zur Bereitstellung für das Beginnen einer nachfolgenden Umsetzung.

4. Messverfahren nach einem der Ansprüche 1 oder 2, bei dem die Logikeinheit (5) einen Entscheidungszähler (13) umfasst, der geeignet ist, sukzessive bei jedem Messzyklus in der zweiten Folge aufeinanderfolgender Messzyklen in Abhängigkeit vom Zustand des Ausgangs des Ladungsverschiebungsverstärkers (4) aufwärts oder abwärts zu zählen, um eine kontinuierliche Zunahme oder eine kontinuierliche Abnahme jedes digitalen Signals zu detektieren, **dadurch gekennzeichnet, dass** in der zweiten Folge von Messzyklen eine Auswahl des letzten digitalen Werts jedes digitalen Signals als digitaler Endwert am Ende der Umsetzung erfolgt, zur Bereitstellung für eine nachfolgende Umsetzung, wenn der Entscheidungszähler (13) in den aufeinanderfolgenden Messzyklen eine Anzahl identischer Zustände des Ausgangs des Ladungsverschiebungsverstärkers (4) aufwärts oder abwärts gezählt hat, die größer ist als eine vorherbestimmte Schwelle.

5. Messverfahren nach einem der vorhergehenden Ansprüche, bei dem der kapazitive Aufnehmer vom triaxialen Typ ist mit drei Paaren von in Differentialanordnung geschalteten Kondensatoren (C1X, C2X, C1Y, C2Y, C1Z, C2Z) mit einer gemeinsamen Elektrode (CM) pro Paar oder für alle Paare und zwei feststehenden Elektroden für jedes Paar, und die Logikeinheit (5) des elektronischen Schaltkreises in der Lage ist, die ersten und zweiten digitalen Messsignale für jede Messeachse X, Y und Z bereitzustellen, **dadurch gekennzeichnet, dass** das Verfahren 12 aufeinanderfolgende Phasen je Messzyklus umfasst, die darin bestehen, nacheinander während der ersten sechs Phasen die Schritte a) und b) für jede Achse X, Y, Z mit dem ersten digitalen Signal zu wiederholen, das der ausgewählten Achse entspricht, und während der letzten sechs Phasen die Schritte c) und d) für jede Achse X, Y, Z mit dem zweiten digitalen Signal zu wiederholen, das der ausgewählten Achse entspricht.

6. Messverfahren nach einem der vorhergehenden Ansprüche, **dadurch gekennzeichnet, dass** bei jeder Messumsetzung 16, 32, 40 oder 60 Messzyklen durchgeführt werden und dass die erste Folge aufeinanderfolgender Messzyklen zwischen 2 und 8 Messzyklen mit einem ersten Schrittwert umfasst, der gleich 32 oder 64 ist auf einer Skala von 0 bis 1023 für jedes Binärwort der digitalen Signale mit 10 Bits.

7. Messverfahren nach Anspruch 4, **dadurch gekennzeichnet, dass** der Entscheidungszähler (13) aufwärts oder abwärts eine Anzahl aufeinanderfolgender identischer Zustände des Ausgangs des Ladungsverschiebungsverstärkers (4) zählt, die größer ist als eine Schwelle von 8, um den letzten gespeicherten, digitalen Wert jedes digitalen Signals als digitalen Endwert auszuwählen.

8. Elektronischer Schnittstellen-Schaltkreis (1) eines kapazitiven Aufnehmers, der ein Paar in Differentialanordnung geschaltete Kondensatoren (C1X, C2X) umfasst zur Durchführung des Messverfahrens nach einem der vorhergehenden Ansprüche, wobei der elektronische Schaltkreis einen Ladungsverschiebungsverstärker (4), der über eine Umschalteinheit (3) an eine gemeinsame Elektrode (CM) angeschlossen ist, eine Logikeinheit (5), die an den Ausgang des Verstärkers für eine digitale Verarbeitung der von dem Verstärker gelieferten Information und für die Bereitstellung von ersten und zweiten digitalen Messsignalen angeschlossen ist, die jeweils von einer ersten Vorspannung der feststehenden Elektroden der Kondensatoren und einer zweiten, zu der ersten Vorspannung umgekehrten Vorspannung abhängen, und einen Digital-Analog Wandler (7) umfasst, der geeignet ist, über die Umschalteinheit (3) eine Messspannung ($V_{DAC}$) an die Elektroden zu liefern, wobei die Messspannung auf der Basis einer Konversion des auf das erste, in einem ersten Register der Logikeinheit (5) gespeicherte digitale Signal oder auf das zweite, in einem zweiten Speicher der Logikeinheit (5) gespeicherte digitale Messsignal bezogene Binärwort (DACbus) definiert ist,

**dadurch gekennzeichnet, dass** die Logikeinheit (5) ein Element (15) zur Bildung eines Mittelwerts, das mit den Registern (14) verbunden ist, wobei das Element (15) dazu bestimmt ist, einen Mittelwert der aufeinanderfolgenden ersten digitalen Signale und einen Mittelwert der aufeinanderfolgenden zweiten digitalen Signale zumindest in einem Teil der zweiten Folge von Messzyklen einer Umsetzung zu bilden, und einen Entscheidungszähler (13) aufweist, der geeignet ist, bei jedem Messzyklus einer Umsetzung in Abhängigkeit des Zustands an dem Ausgang des Ladungsverschiebungsverstärkers (4) aufwärts oder abwärts zu zählen, wobei der Entscheidungszähler dazu bestimmt ist, zu steuern, die Auswahl des letzten digitalen Werts des ersten digitalen Signals und des zweiten digitalen Signals am Ende einer Umsetzung, wenn das Aufwärtszählen oder das Abwärtszählen identischer aufeinanderfolgender Zustände eine vorherbestimmte Schwelle überschreitet, oder die Auswahl des Mittelwerts der ersten digitalen Signale und des Mittelwerts der zweiten digitalen Signale für eine nachfolgende Umsetzung in den Registern zu speichern, wenn die Schwelle des Aufwärtszählens oder des Abwärtszählens des Entscheidungszählers (13) nicht überschritten ist.

9. Elektronischer Schaltkreis (1) nach Anspruch 8 als Schnittstelle eines triaxialen kapazitiven Aufnehmers, der drei Paare von in Differentialanordnung geschalteten Kondensatoren (C1X, C2X, C1Y, C2Y, C1Z, C2Z) umfasst, **dadurch gekennzeichnet, dass** er einen einzigen Ladungsverschiebungsverstärker (4) für die Messung längs der drei Messachsen X, Y, Z des Aufnehmers umfasst, wobei der Verstärker es vermag, eine Information vom digitalen Typ an die Logikeinheit (5) zu liefern, um dem Entscheidungszähler (13) zu ermöglichen, eine Aufwärts- oder eine Abwärtszählung in Abhängigkeit vom Zustand des Ausgangs des Ladungsverschiebungsverstärkers (4) in jedem nachfolgenden Messzyklus einer Umsetzung durchzuführen, und dadurch, dass die Logikeinheit (5) die ersten und zweiten digitalen Messsignale für jede Messachse X, Y, Z liefert.

10. Elektronischer Schaltkreis (1) nach Anspruch 9, **dadurch gekennzeichnet, dass** die Logikeinheit (5) sechs Register umfasst, um die ersten und die zweiten digitalen Messsignale für jede Achse zu speichern, wobei jedes Register mit 10 Bits definiert ist.

11. Elektronischer Schaltkreis (1) nach einem der Ansprüche 8 bis 10, **dadurch gekennzeichnet, dass** er einen Multiplexer (16), der durch ein Befehlssignal des Entscheidungszählers (13) gesteuert ist, um am Ausgang entweder das letzte digitale Signal jedes Registers, wenn eine Überschreitung der vorherbestimmten Schwelle nach dem Aufwärts- oder Abwärtszählen in dem Entscheidungszähler (13) vorliegt, oder den Mittelwert der ersten und zweiten aufeinanderfolgenden digitalen Signale für jede Achse in der zweiten Folge von Messzyklen zu liefern, wenn die vorherbestimmte Schwelle nicht überschritten ist, und ein Element (17) zur Verknüpfung der von dem Multiplexer (16) empfangenen, ersten und zweiten digitalen Signale für jede Achse umfasst, um digitale Ausgangssignale ($OUT_{DX}$, $OUT_{DY}$, $OUT_{DZ}$) für jede Achse zu liefern.

## Claims

1. Method of measuring a physical parameter by means of an electronic interface circuit (1) connected to a capacitive sensor (2), which includes at least two differential connected capacitors (C1X, C2X) whose a common electrode (CM) is capable of moving relative to each fixed electrode of the two capacitors to alter the capacitive value of each capacitor when the physical parameter is being measured, said electronic circuit including a charge transfer amplifier (4), which is connected to the common electrode (CM) via a switching unit (3), a logic unit (5) connected to the amplifier output for digital processing of the data supplied by the amplifier and for supplying digital measuring signals, and a digital-analogue converter (7) capable of supplying a measurement voltage ($V_{DAC}$) to the electrodes via the switching unit (3), the measurement voltage being defined on the basis of a binary word (DACbus) conversion defining at least one of the digital measuring signals,

the method including several successive measuring cycles for a measurement conversion, wherein each successive measuring cycle comprises the steps of:

a) biasing the electrodes of the capacitors (C1X, C2X, CM) via the switching unit (3) with a measuring voltage ($V_{DAC}$) supplied by the digital-analogue converter (7) on the basis of a first digital measuring signal from a preceding cycle or a first initial binary word supplied by the logic unit (5), the first digital signal depending on a first biasing of the fixed electrodes of the capacitors,

b) connecting the fixed electrodes of the capacitors (C1X, C2X) via the switching unit (3) respectively each to the terminals of a supply voltage ($V_{REG}$, Vss) source for a first biasing of the fixed electrodes,

c) biasing the electrodes of the capacitors (C1X, C2X, CM) via the switching unit (3) with a measuring voltage ($V_{DAC}$) supplied by the digital-analogue converter (7) on the basis of a second digital measuring signal from a preceding cycle or a second initial binary word supplied by the logic unit (5), the second digital signal depending on a second biasing which is the reverse of the first biasing of the fixed electrodes of the capacitors,

d) connecting the fixed electrodes of the capacitors (C1X, C2X) via the switching unit (3) respectively each to the terminals of a supply voltage ($V_{REG}$, Vss) source for a second biasing of the fixed electrodes, which is the inverse of the first biasing,

**characterized in that** the method starts each conversion with a first series of successive measuring cycles, in which the first and second digital signals are adapted in the logic unit (5) to each measuring cycle by adding or subtracting a first determined step value greater than 2 on the basis of data supplied by the charge transfer amplifier (4) and with a second series of successive measuring cycles after the first series of measuring cycles, in which the first and second digital signals are adapted in the logic unit (5) to each measuring cycle by adding or subtracting a second determined step value equal to 1 or 2, until the end of the measurement conversion.

2. Measuring method according to claim 1, wherein the logic unit (5) includes a first register for storing the first digital measuring signal in 10 bits, and a second register for storing the second digital measuring signal in 10 bits, **characterized in that** each measurement conversion starts on the basis of a final digital value for each digital signal stored in the first register and the second register (14) from a preceding conversion.

3. Measuring method according to any of the preceding claims, **characterized in that** a mean is calculated of the digital signals stored in succession in the logic unit (5) in at least a final part of the successive measuring cycles of the second series of measuring cycles, in order to store the mean of each digital signal as the final digital value in the corresponding register to be supplied to start a subsequent conversion.

4. Measuring method according to any of claims 1 or 2, wherein the logic unit (5) includes a decision counter (13) capable of counting or counting down in succession according to the state of the charge transfer amplifier (4) output in each measuring cycle in the second series of successive measuring cycles, so as to detect a continual increase or a continual decrease in each digital signal, **characterized in that** in the second series of measuring cycles, the last digital value stored for each digital signal is selected as the final digital value at the end of the conversion to be supplied for a subsequent conversion, if the decision counter (13) has counted or counted down, in successive measuring cycles, a higher number of identical output states of the charge transfer amplifier (4) than a predetermined threshold.

5. Measuring method according to any of the preceding claims, wherein the capacitive sensor is of the tri-axis type with three pairs of differential connected capacitors (C1X, C2X, C1Y, C2Y, C1Z, C2Z) with one common electrode (CM) per pair or for all the pairs and two fixed electrodes for each pair, and the logic unit (5) of the electronic circuit is capable of supplying first and second digital measuring signals for each measuring axis X, Y and Z, **characterized in that** the method includes 12 successive phases per measuring cycle, which consist in repeating steps a) and b) in succession during the first six phases for each axis X, Y, Z with the first digital signal corresponding to the selected axis, and in repeating steps c) and d) in succession during the last six phases for each axis X, Y, Z with the second digital signal corresponding to the selected axis.

6. Measuring method according to any of the preceding claims, **characterized in that** 16, 32, 40 or 64 measuring cycles are carried out in each measurement conversion, and **in that** the first series of successive measuring cycles includes between 2 and 8 measuring cycles with a first step value equal to 32 or 64 on a scale from 0 to 1023 for each 10-bit binary word of the digital signals.

7. Measuring method according to claim 4, **characterized in that** the decision counter (13) counts or counts down a number of successive identical output states of the charge transfer amplifier (4) higher than a threshold equal to 8, to select the last digital value stored for each digital signal as the final digital value.

8. Electronic interface circuit (1) for a capacitive sensor, which includes a pair of differential connected capacitors (C1X, C2X) for implementing the measuring method according to any of the preceding claims, the electronic circuit including a charge transfer amplifier (4) connected to the common electrode (CM) via a switching unit (3), a logic unit (5) connected to the amplifier output for digital processing of the data supplied by the amplifier and for supplying first and second digital measuring signals, dependent respectively on a first biasing of the fixed electrodes of the capacitors and a second biasing which is the reverse of the first biasing, and a digital-analogue converter (7) capable of supplying a measuring voltage ($V_{DAC}$) to the electrodes via the switching unit (3), the measuring voltage being defined on the basis of a binary word (DACbus) conversion relating to the first digital signal stored in a first register of the logic unit (5) or the second digital measuring signal stored in a second register of the logic unit (5), **characterized in that** the logic unit (5) includes an element (15) for calculating a mean connected to the registers (14), said element (15) being intended to calculate a mean of the first successive digital signals and a mean of the second successive digital signals in at least part of the second series of measuring cycles of a conversion, and a decision counter (13) capable of counting or counting down according to the output state of the charge transfer amplifier (4) for each measuring cycle of a conversion, the decision counter being intended to order the selection of the last digital value of the first digital signal and of the second digital signal at the end of a conversion, if the count or countdown of successive identical states exceeds a predetermined threshold, or the selection of the mean of the first digital signals and the mean of the second digital signals to be stored in the registers if the count or countdown threshold of the decision counter (13) is not exceeded, for a subsequent conversion.

9. Electronic circuit (1) according to claim 8, as an interface for a tri-axis capacitive sensor, which includes three pairs of differential connected capacitors (C1X, C2X, C1Y, C2Y, C1Z, C2Z), **characterized in that** it includes a single charge transfer amplifier (4) for measurement on the three measuring axes X, Y and Z of the sensor, the amplifier being capable of supplying digital data to the logic unit (5), to allow the decision counter (13) to carry out a count or countdown according to the output state of the charge transfer amplifier (4) in each successive measuring cycle of a conversion, and **in that** the logic unit (5) supplies first and second digital measuring signals for each measurement axis X, Y and Z.

10. Electronic circuit (1) according to claim 9, **characterized in that** the logic unit (5) includes six registers for storing the first and second digital measuring signals for each axis, each register being defined in 10 bits.

11. Electronic circuit (1) according to any of claims 8 to 10, **characterized in that** it includes a multiplexer (16) controlled by a command signal from the decision counter (13), so as to supply at output either the last digital signal of each register, if the predetermined threshold is exceeded following the count or countdown in the decision counter (13), or the mean of the first and second successive digital signals of each axis in the second series of measuring cycles, if the predetermined threshold has not been exceeded, and an element (17) for combining the first and second digital signals of each axis received from the multiplexer (16) in order to supply digital output signals for each axis (OUTDX, OUTDY, OUTDZ).

Fig. 1

Fig. 2a

Fig. 2b

Fig. 3a

Fig. 3b

Fig. 4

**EP 2 618 164 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1835263 A
- WO 2004113930 A
- WO 2008107737 A
- EP 2343507 A
- EP 2343507 A1

**Littérature non-brevet citée dans la description**

- **MM. H. LEUTHOLD ; F. RUDOLPH.** Sensors and actuators. 1990, vol. A21-A23, 278-281
- A 1 mV MOS Comparator. IEEE J. Solid-State Circuits. Juin 1978, vol. SC-13, 294-298